# EUROPÄISCHE PATENTSCHRIFT

(11) **EP 2 654 392 B1**
(45) Veröffentlichungstag und Bekanntmachung des Hinweises auf die Patenterteilung: **04.04.2018**
(21) Anmeldenummer: 13154311.8
(22) Anmeldetag: 07.02.2013
(51) Int. Cl.: H05K 7/20, H01L 23/473, H01L 25/07, H01L 25/11

(54) **Anreihbares flüssigkeitsgekühltes Leistungshalbleitermodul und Anordnung hiermit**
In-line liquid cooled semiconductor module and assembly with the same
Module semi-conducteur de puissance refroidi par liquide pouvant être joint et agencement à cet effet

(30) Priorität: 17.04.2012 DE 102012206264
(43) Veröffentlichungstag der Anmeldung: 23.10.2013
(73) Patentinhaber: SEMIKRON Elektronik GmbH & Co. KG, 90431 Nürnberg (DE)
(72) Erfinder: Beckedahl, Peter, 90522 Oberasbach (DE); Steger, Jürgen, 91355 Hiltpoltstein (DE); Maul, Andreas, 90461 Nürnberg (DE); Knebel, Markus, 90587 Tuchenbach (DE); Kalla, Susanne, 92263 Ebermannsdorf (DE)

(56) Entgegenhaltungen:
- EP-A1- 0 669 653
- EP-A1- 2 001 048
- EP-B1- 1 815 514
- WO-A1-2011/127931
- US-A1- 2010 302 733

## Beschreibung

Die Erfindung beschreibt ein Leistungshalbleitermodul insbesondere geeignet für den Einsatz in dezentralen Energieversorgungseinrichtungen. Hierfür ist dieses mit einer Flüssigkeitskühleinrichtung vorgesehen und derart ausgebildet, dass eine Mehrzahl dieser Leistungshalbleitermodule mittels ihrer Vor- und Rückläufe aneinander anreihbar sind. Durch diese Anreihung entsteht eine Anordnung, die beispielhaft als Wechselrichterschaltung in Windkraftanlagen einsetzbar ist.

Grundsätzlich sind anreihbare Leistungshalbleitermodule beispielhaft aus der DE 103 16 356 A1 bekannt. Die dort Teilmodule genannten Leistungshalbleitermodule weisen ein Gehäuse, sowie Last- und Hilfsanschlusseinrichtungen auf. Die Leistungshalbleitermodule sind nebeneinander auf einer Kühleinrichtung anordenbar und mittels Verbindungseinrichtungen zu einer Gesamtanordnung verbunden.

Weiterhin sind aus der EP 1 815 514 B1 Durchflussverteilungsmodule und eine entsprechende Anordnung hieraus bekannt. Hierbei weist das Durchflussverteilermodul als Teil eines Kühlsystems ein Gehäuse, einen Einlassverteiler, einen Auslassverteiler und eine Vielzahl von Durchflusszellen auf. Diese Zellen können als offene Zellen ausgebildet sein, wobei in die Öffnung eine leistungselektronische Schalteinrichtung eingesetzt werden kann. Hierbei entsteht eine abzudichtende Fläche zwischen dem Durchflussverteilermodul und der leistungselektronischen Schalteinrichtung.

Aus der EP 2 001 048 A1 eine Mehrzahl von Leistungshalbleitereinrichtungen bekannt, die zur direkten Kühlung von Leistungshalbleiterbauelementen ausgebildet sind. Diese Leistungshalbleitereinrichtungen sind vertikal übereinander angeordnet, jeweils mit Anschlusseinrichtungen für Kühlmittel wie auch für elektrische Verbindungen, und bilden eine leistungselektronische Schaltung aus. Diese Leistungshalbleitereinrichtungen sind jeweils gleichartig ausgebildet und derart zueinander angeordnet, dass sie eine elektrische Anschlussanordnung ausbilden, wobei die einzelnen Anschlusseinrichtungen seitlich versetzt zueinander angeordnet sind.

In der EP 0 669 653 A1 wird eine Schaltungsanordnung und ein Leistungshalbleitermodul offenbart, wobei die Schaltungsanordnung mehrere parallelgeschaltete Leistungshalbleitermodule umfasst, von denen nur eines mit einer Steuervorrichtung verbunden ist. Die übrigen Module arbeiten als Slaves des mit der Steuervorrichtung verbundenen Masters und beziehen die zur Ansteuerung benötigten Signal über einen Signal-Bus vom Master. Zu diesem Zweck weisen die Leistungshalbleitermodule eine Anzahl von Signalanschlüssen auf, welche untereinander verbunden sind. Die Signalanschlüsse können mit den Steueranschlüssen z.B. via eine Schnittstelle signalmässig verbunden werden. Mit den erfindungsgemässen Leistungshalbleitermodulen erhält man eine Schaltungsanordnung, in welcher mehrere Module bis höchsten Leistungen ohne Einschränkungen parallelgeschaltet werden können.

In Kenntnis dieses Standes der Technik liegt der Erfindung die Aufgabe zugrunde, ein anreihbares flüssigkeitsgekühltes Leistungshalbleitermodul vorzustellen, das keine internen Dichtflächen aufweist, flexibel mit verschiedenen leistungselektronischen Schaltungen ausbildbar ist und einer einfachen und für die Lastanschlüsse niederinduktiven externen Verbindung zugänglich ist. Ebenso ist es Aufgabe dieser Erfindung eine Anordnung mit einer Mehrzahl dieser Leistungshalbleitermodule vorzustellen, die deren Vorteile nutzt.

Diese Aufgabe wird erfindungsgemäß gelöst durch ein Leistungshalbleitermodul mit den Merkmalen des Anspruchs 1 und eine Anordnung gemäß Anspruch 8. Bevorzugte Ausführungsformen sind in den jeweiligen abhängigen Ansprüchen beschrieben.

Das erfindungsgemäße Leistungshalbleitermodul weist eine quaderförmige Grundform auf, wodurch zwei Haupt-, zwei Längs- und zwei Schmalseiten, die sich jeweils paarweise gegenüberliegen, definiert werden. Die Hauptseiten sind weiterhin dadurch definiert, dass bezogen auf die quaderförmige Grundform ihr Flächeninhalt der größte ist, während entsprechend derjenige Flächeninhalt der Schmalseiten der kleinste ist. Diese jeweiligen Seiten bilden unter Beibehaltung der quaderförmigen Grundform nicht zwangsläufig vollständig ebene Flächen aus, vielmehr können die Flächen der jeweiligen Seiten Einzüge und alternativ oder zusätzlich Ausnehmungen, beispielhaft für Anschlusselemente aufweisen.

Das Leistungshalbleitermodul weist weiterhin eine durchströmbare Kühleinrichtung, eine leistungselektronische Schalteinrichtung und ein Gehäuse auf. Hierbei weist die Kühleinrichtung vier Anschlusseinrichtungen für die Kühlflüssigkeit und ein Kühlvolumen mit mindestens einer Kühlfläche auf. Unter Kühlvolumen soll hierbei insbesondere eine einzelne durchströmbare Kammer oder eine Mehrzahl parallel oder seriell durchströmbarer Kammern verstanden werden. Diese Kammern bilden Hohlräume der Kühleinrichtung aus, wobei an mindestens einem dieser Hohlräume mindestens eine Kühlfläche angrenzt. Die mindestens eine Kühlfläche ist vorzugsweise parallel zu den Hauptseiten angeordnet. Das Kühlvolumen ist zur jeweiligen Kühlfläche hin dicht. Somit ist das Innere des Leistungshalbleitermoduls frei von internen Dichtflächen, die interne Dichteinrichtungen bedingen würden.

Die vier Anschlusseinrichtungen der Kühleinrichtung für die Kühlflüssigkeit sind paarweise an den Hauptseiten des Leistungshalbleitermoduls angeordnet. Die Anschlusseinrichtungen für die Kühlflüssigkeit sind ausgebildet als jeweils ein Vorlaufzu- und ein Vorlaufabfluss sowie als eine Rücklaufzu- und ein Rücklaufabfluss. Unter Vorlauf wird hierbei insbesondere derjenige Flüssigkeitsstrom verstanden, der die Kühlflüssigkeit zu einem zu kühlenden Gegenstand transportiert, während der Rücklauf insbesondere derjenige Flüssigkeitsstrom ist, der nach dem Wärmeübergang vom zu kühlenden Gegenstand die Kühlflüssigkeit wegtransportiert.

In einer ersten bevorzugten Ausgestaltung sind der Vorlaufzufluss und der Rücklaufabfluss, sowie der Vorlaufabfluss und der Rücklaufzufluss jeweils auf einer Hauptseite des Leistungshalbleitermoduls angeordnet. Die jeweiligen Zu- und Abflüsse weisen hierbei selbstverständlich zugeordnete und durch ihre Funktion definierte Anschlusseinrichtungen auf.
In einer zweiten bevorzugten Ausgestaltung sind der Vorlaufzufluss und der Rücklaufzufluss, sowie der Vorlaufabfluss und der Rücklaufabfluss jeweils auf einer Hauptseite angeordnet.

Vorzugsweise weist die Kühleinrichtung des Leistungshalbleitermoduls zwischen dem Vorlaufzu- und dem Vorlaufabfluss einen ersten Abzweig sowie zwischen Rücklaufzu- und Rücklaufabfluss einen zweiten Abzweig auf, wodurch das Kühlvolumen der Kühleinrichtung mit Kühlflüssigkeit vom Vorlauf zum Rücklauf hin durchströmbar ist.

Die leistungselektronische Schalteinrichtung weist eine leistungselektronische Schaltung auf, die auf der mindestens einen Kühlfläche angeordnet und über diese thermisch mit der Kühlflüssigkeit verbunden ist, wodurch entstehende Wärme an die Kühlflüssigkeit abgegeben werden kann. Es kann bevorzugt sein die leistungselektronische Schaltung mittels einzelner Schaltmodule auszubilden. Weiterhin kann es bevorzugt sein diese Schaltmodule paarweise auf jeweils zwei sich bezogen auf das Kühlvolumen gegenüberliegende Kühlflächen anzuordnen.

Weiterhin weist die leistungselektronische Schalteinrichtung Lasteingangs- und Lastausgangsanschlusseinrichtungen auf, die jeweils an einer oder beiden Längsseiten angeordnet sind. Diese Lasteingangs- und Lastausgangsanschlusseinrichtungen dienen der externen Verbindung der leistungselektronischen Schaltung. Es kann vorteilhaft sein, die Lasteingangsanschlusseinrichtungen an einer ersten Längsseite und die Lastausgangsanschlusseinrichtungen an der gegenüberliegenden Längsseite anzuordnen.

Ebenso weist die leistungselektronische Schalteinrichtung eine Steueranschlusseinrichtung auf, die an einer Schmalseite angeordnet ist. Diese Steueranschlusseinrichtung dient insbesondere der externen Verbindung von Steuer-, Fehler- und Sensorsignalen. Hierbei kann die leistungselektronische Schalteinrichtung neben der leistungselektronischen Schaltung auch noch eine modulinterne Steuerschaltung aufweisen, die beispielhaft die Sekundärseite oder Teil hiervon, zur Ansteuerung der leistungselektronischen Schaltung aufweist.

Weiterhin weist das Leistungshalbleitermodul ein Gehäuse, das in einer ersten bevorzugten Ausgestaltung ausschließlich die leistungselektronische Schaltung überdeckt und Ausnehmungen für deren Anschlusseinrichtungen auf. Hierbei kann das Gehäuse auch als eine staub- und feuchtigkeitsdichte Verkapselung ausgebildet sein.

In einer zweiten bevorzugten Ausgestaltung ist das Gehäuse als eine staub- und feuchtigkeitsdichte Verkapselung des gesamten Leistungshalbleitermoduls ausgebildet, das die leistungselektronische Schaltung und die Kühleinrichtung einschließt, wobei ausschließlich die notwendigen Anschlusseinrichtungen durch das Gehäuse hindurchreichen.

Die erste Ausgestaltung der erfindungsgemäßen Anordnung aus einer Mehrzahl oben genannter Leistungshalbleitermodule ist ausgebildet, indem der Vorlaufabfluss eines Leistungshalbleitermoduls mit dem Vorlaufzufluss und der Rücklaufzufluss mit dem Rücklaufabfluss des nachfolgenden Leistungshalbleitermoduls mittelbar oder unmittelbar verbunden sind. Unter einer unmittelbaren Verbindung ist hierbei eine Verbindung zu verstehen bei der die korrespondierenden Anschlusseinrichtungen direkt unter ausschließlicher Ergänzung durch notwendige externe Dichteinrichtungen verbunden sind. Unter einer mittelbaren Verbindung ist hierbei eine Verbindung zu verstehen, bei der die korrespondierenden Anschlusseinrichtungen nicht direkt, sondern mittels geeigneter Verbindungselemente und notwendiger externer Dichteinrichtungen verbunden sind. Unter externer Dichteinrichtung werden hier Dichteinrichtungen verstanden, die außen an dem Leistungshalbleitermodul anordenbar sind.

In einer zweiten Ausgestaltung sind die Leistungshalbleitermodule aneinandergereiht, indem der Vorlaufabfluss eines Leistungshalbleitermoduls mit dem Vorlaufzufluss und der Rücklaufabfluss mit dem Rücklaufzufluss des nachfolgenden Leistungshalbleitermoduls mittelbar oder unmittelbar verbunden sind.

Hierbei ist es jeweils in beiden Ausgestaltungen bevorzugt, wenn die Lasteingangs- und Lastausgangsanschlusseinrichtungen aller Leistungshalbleitermodule jeweils auf der gleichen Längsseite angeordnet sind. Dies dient insbesondere der niederinduktiven externen Verschaltung der Leistungshalbleitermodule. Zudem wird hierdurch der externe Verschaltungsaufwand äußerst gering gehalten.

Ebenso kann es bevorzugst sein, wenn die Steueranschlusseinrichtung aller Leistungshalbleitermodule jeweils auf der gleichen Schmalseite angeordnet sind. Auch dieses dient der besonders einfachen externen Verbindung, insbesondere wenn mindestens zwei Steueranschlusseinrichtungen von zugeordneten benachbarten Leistungshalbleitermodulen mit einer gemeinsamen externen Steuerplatine verbunden sind.

Bei Ausgestaltung der Anordnung als mehrphasiger Wechselrichter kann es auch vorteilhaft sein, wenn diejenigen Leistungshalbleitermodule, deren Steueranschlusseinrichtungen mittels einer gemeinsamen externen Steuerplatine verbundenen sind, einer elektrischen Phase des Wechselrichters eines Wechselstromsystems zugeordnet sind. Durch diese Aufteilung der Steuersignale auf mehrere Steuerplatinen kann der Aufbau vereinfacht und alternativ oder gleichzeitig die Störsicherheit erhöht werden.

Durch die genannten Ausgestaltungen der Leistungshalbleitermodule und der daraus aufgebauten Anordnung können grundsätzlich gleichartige Leistungshalbleitermodule für verschiedene Schaltungstopologien, insbesondere für Zwei- und Dreilevel-Wechselrichter, verwendet werden. Durch die Anreihbarkeit und flexible Ausgestaltung der leistungselektronischen Schaltungen ergibt sich auch eine einfach skalierbare Ausgestaltung, wodurch insbesondere Wechselrichter mit unterschiedlichen Leistungen nur durch die Anzahl der anzureihenden Leistungshalbleitermodule in der Leistung skaliert werden können.

Weitere Erläuterungen der Erfindung sowie vorteilhafte Einzelheiten und Merkmale ergeben sich aus der nachfolgenden Beschreibung der in den Fig. 1 bis 7 dargestellten Ausführungsbeispiele des erfindungsgemäßen Leistungshalbleitermodul bzw. der erfindungsgemäßen Anordnung.
Figur 1 zeigt in dreidimensionaler Ansicht ein erfindungsgemäßes Leistungshalbleitermodul.
Figur 2 zeigt schematisch eine Draufsicht aus Richtung einer Längsseite auf einen Schnitt durch ein erfindungsgemäßes Leistungshalbleitermodul.
Figur 3 zeigt eine Draufsicht aus Richtung einer Hauptseite auf ein erfindungsgemäßes Leistungshalbleitermodul ohne Gehäuse.
Figuren 4 und 5 zeigen schematisch Draufsichten aus Richtung einer Längsseite auf einen Schnitt durch ein weiteres erfindungsgemäßes Leistungshalbleitermodul.
Figur 6 zeigt eine dreidimensionale Ansicht einer ersten Ausgestaltung der erfindungsgemäßen Anordnung.
Figur 7 zeigt eine dreidimensionale Ansicht einer zweiten Ausgestaltung der erfindungsgemäßen Anordnung.

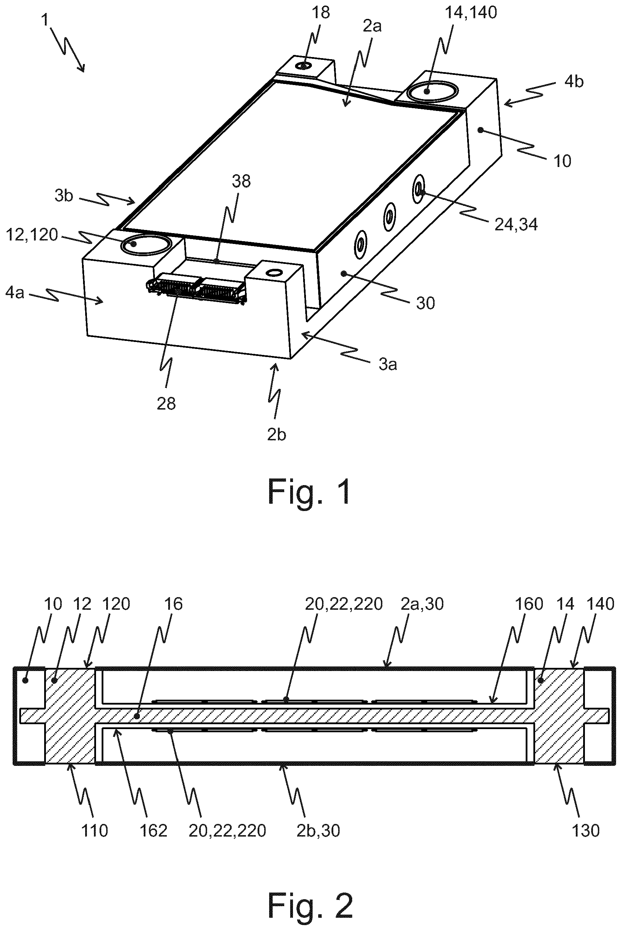

Figur 1 zeigt in dreidimensionaler Ansicht ein erfindungsgemäßes Leistungshalbleitermodul 1, bei der die quaderförmige Grundform deutlich erkennbar ist. Das Leistungshalbleitermodul 1 weist somit zwei Hauptseiten 2 a/b auf, auf denen jeweils eng benachbart zu den Längs- 3 a/b und Schmalseiten 4 a/b in gegenüberliegenden Ecken die Anschlusseinrichtungen 110, 120, 130, 140 für die Kühlflüssigkeit angeordnet sind. Diese Anschlusseinrichtungen 110, 120, 130, 140 sind Teil der Kühleinrichtung 10 des Leistungshalbleitermoduls 1. Auf der ersten Hauptseite 2a sind hier ein Vorlaufabfluss 120 und ein Rücklaufabfluss 140 dargestellt. In den beiden verbleibenden Ecken sind die Kühleinrichtung 10 zwischen den Hauptflächen 2 a/b durchdringende Ausnehmungen 18 vorgesehen, die bei der Aneinanderreihung einer Mehrzahl von Leistungshalbleitermodulen 1 zu deren Verbindung dienen.

Ebenfalls dargestellt ist das Gehäuse 30 des Leistungshalbleitermoduls 1, das die Ausnehmung der U-förmig ausgebildeten Kühleinrichtung 10 überdeckt und dabei wesentliche Teile der ersten Hauptseite 2a ausbildet. Durch das Gehäuse 30 überdeckt und nicht sichtbar ist die leistungselektronische Schaltung 22 der leistungselektronischen Schalteinrichtung 20 des Leistungshalbleitermoduls 1 angeordnet. Von der leistungselektronischen Schalteinrichtung 20 sichtbar sind Lastanschlusseinrichtungen 24, 26, hier Lastausgangsanschlusseinrichtungen 26, sowie Steueranschlusseinrichtungen 28. Diese durchdringen das Gehäuse 30 an zugeordneten Ausnehmungen 34, 36, 38, die Lastanschlusseinrichtungen 24, 26 an Längs- 3a /b , die Steueranschlusseinrichtungen 28 an einer Schmalseite 4a des Leistungshalbleitermoduls 1.

Figur 2 zeigt schematisch eine Draufsicht aus Richtung einer Längsseite 3a auf einen Schnitt durch ein erfindungsgemäßes Leistungshalbleitermodul 1. Dargestellt ist hier eine doppel-U-förmige Kühleinrichtung 10 mit einem Vorlaufabfluss 120 und einem Rücklaufabfluss 140 an einer ersten Hauptseite 2a, während der jeweils korrespondierende Vorlaufzufluss 110 und der Rücklaufzufluss 130 auf der zweiten Hauptseite 2b angeordnet sind. Zwischen Vor- 12 und Rücklauf 14 ist das durchströmbare Kühlvolumen 16 angeordnete.

Dieses Kühlvolumen 16 weist hier nur eine Kammer auf, der zwei Kühlflächen 160, 162 zugeordnet sind. Auf jeder der beiden Kühlflächen 160, 162 sind Schaltmodule 220 der leistungselektronischen Schaltung 22 angeordnet. Jeweils zwei gegenüber angeordnete Schaltmodule 220 sind einer Phase einer dreiphasigen Wechselrichterschaltung zugeordnet.

Das Gehäuse 30 dieses Leistungshalbleitermoduls 1 ist als eine staub- und feuchtigkeitsdichte Verkapselung ausgebildet, die ausschließlich Öffnungen, hier nicht dargestellte Ausnehmungen 34, 36, 38, für die Durchführung der notwendigen externen Anschlusseinrichtungen, aufweist und im Übrigen sowohl die leistungselektronische Schaltung 22, wie auch die gesamte Kühleinrichtung 10 umgibt. Die notwendigen Anschlusseinrichtungen sind hierbei die vier Anschlusseinrichtungen 110, 120, 130, 140 für die Kühlflüssigkeit, und die nicht dargestellten Last- 24, 26 und Steueranschlussleitung 28 der leistungselektronischen Schalteinrichtung 20.

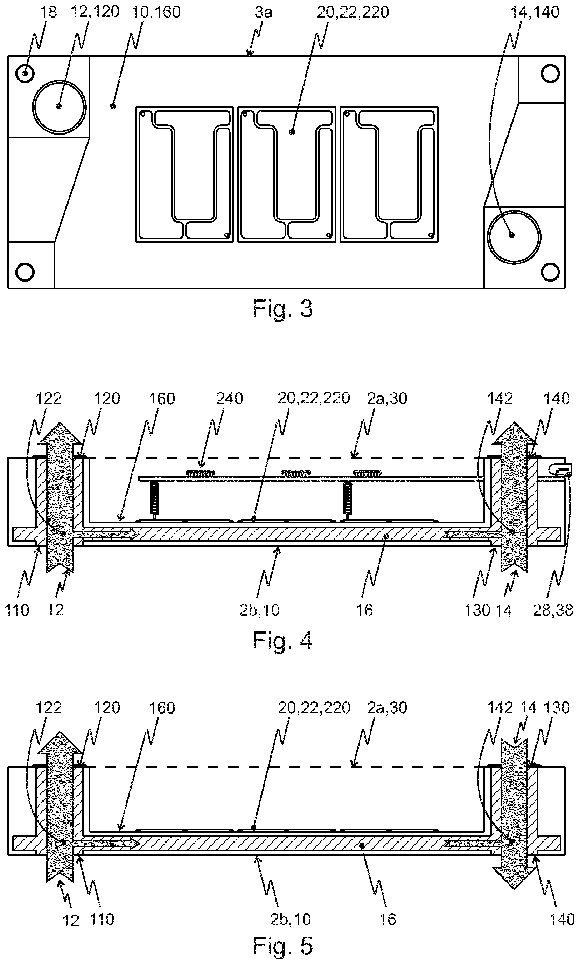

Figur 3 zeigt eine Draufsicht aus Richtung einer Hauptseite 2a auf ein erfindungsgemäßes Leistungshalbleitermodul 1 ohne Gehäuse. Dargestellt ist hier wiederum eine U-förmige Kühleinrichtung 10 mit einem Vorlaufabfluss 120 und einem Rücklaufabfluss 140 in gegenüberliegenden Ecken der ersten Hauptseite 2a. Zusätzlich sind in allen Ecken der Kühleinrichtung 10 von erster 2a zu zweiter Hauptseite 2b hindurchreichende nicht mit dem Kühlkreislauf verbundene Ausnehmungen 18 vorgesehen, die der Verbindung zu weiteren Leistungshalbleitermodulen dienen, indem hierdurch Schraubverbindungen zur Klemmung der Leistungshalbleitermodule zueinander anordenbar sind.

Weiterhin dargestellt ist eine Kühlfläche 160 auf der drei Schaltmodule 220 der leistungselektronischen Schaltung 22 angeordnet sind. Die von diesen Submodulen 220 zu den Längsseiten 3 a/b reichenden Lastanschlusseinrichtungen 24, 26 sind ebenso wie die von diesen Submodulen 220 zu einer Schmalseite 4 a/b reichende Hilfsanschlusseinrichtung 28 nicht dargestellt.

Figuren 4 und 5 zeigen schematisch Draufsichten aus Richtung einer Längsseite 3a auf einen Schnitt durch ein weiteres erfindungsgemäßes Leistungshalbleitermodul 1. Dargestellt ist wiederum eine U-förmige Kühleinrichtung 10, die eine zweite Hauptseite 2b sowie die beiden Schmalseiten 4 a/b des Leistungshalbleitermoduls 1 vollständig ausbildet. Ebenso bildet die Kühleinrichtung 10 einen Teil der ersten Hauptseite 2a, wie auch Teile der beiden Längsseiten 3 a/b aus (vgl. Fig. 1). Die übrigen Teile der ersten Hauptseite 2a, wie auch die übrigen Teile der beiden Längsseiten 3 a/b werden durch das Gehäuse 30 ausgebildet.

Im Inneren der U-förmigen Kühleinrichtung 10 sind hier drei Schaltmodule 220 der leistungselektronischen Schaltung 22 auf einer Kühlfläche 160 der Kühleinrichtung 10 angeordnet und sind mittels dieser mit der Kühlflüssigkeit in thermischem Kontakt.

Die Kühlflüssigkeit des Vorlaufs 12 gelangt bei dem Leistungshalbleitermodul 1 gemäß Fig. 4 durch einen Vorlaufzufluss 110 an der zweiten Hauptseite 2b in die Kühleinrichtung 10 und wird dort mittels eines ersten Abzweigs 122 in zwei Teilströme aufgeteilt. Der wesentliche Teil der Kühlflüssigkeit verlässt die Kühleinrichtung 10 des Leistungshalbleitermoduls 1 durch den Vorlaufabfluss 120 an der ersten Hauptseite 2a, während ein kleiner Anteil der Kühlflüssigkeit das Kühlvolumen 16 mit angrenzender Kühlfläche 160 durchströmt.

Ebenfalls an der zweiten Hauptfläche 2b ist der Rücklaufzufluss 130 angeordnet. Die Kühlflüssigkeit des Rücklaufs 14 gelangt durch diesen in die Kühleinrichtung 10 und vereinigt sich an einem zweiten Abzweig 142 mit der Kühlflüssigkeit, die das Kühlvolumen 16 durchströmt hat. Der Rücklauf 14 verlässt die Kühleinrichtung 10 danach durch den Rücklaufabfluss 140 auf der ersten Hauptseite 2a.

Zusätzlich weist dieses Leistungshalbleitermodul 1 noch eine interne Steuerplatine 240 auf, die in fachüblicher Weise mit den Schaltmodulen 220 verbunden ist und Treiberfunktionalität für die leistungselektronische Schaltung 22 bereitstellt. Diese interne Steuerplatine 240 weist als Teil der leistungselektronischen Schalteinrichtung 20 an einer Schmalseite 4a des Leistungshalbleitermoduls 1 eine Steueranschlusseinrichtung 28 auf, die durch eine Ausnehmung 38 des Gehäuses 30 ragt.

Figur 5 zeigt im Grunde das identische Leistungshalbleitermodul 1, wobei hier die interne Steuerplatine nicht dargestellt ist, mit identischen Anschlusseinrichtungen. Allerdings ist hier die Funktion der Anschlusseinrichtungen für Kühlflüssigkeit geändert, da der Rücklaufzufluss 130 auf der ersten 2a und der Rücklaufabfluss 140 auf der zweiten Hauptseite 2b angeordnet sind. Dies ist allerdings nur eine funktionale, keine konstruktive Änderung.

Grundsätzlich ist das Leistungshalbleitermodul gemäß Fig. 4 und 5 somit für verschiedene Flussrichtungen des Vor- 12 bzw. Rücklaufs 14 geeignet. Bei erhöhten Anforderungen an den Wirkungsgrad des ersten, zweiten oder beider Abzweige kann diese Eignung für beliebige Flussrichtung auch aufgegeben werden.

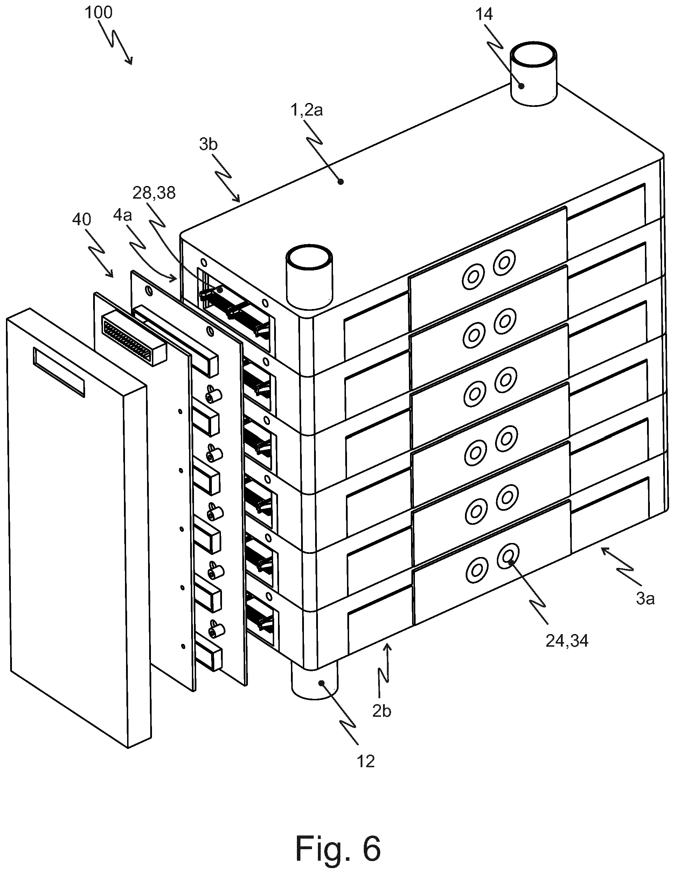

Figur 6 zeigt eine dreidimensionale Ansicht einer ersten Ausgestaltung der erfindungsgemäßen Anordnung 100. Dargestellt ist eine Mehrzahl von anreihbaren Leistungshalbleitermodulen 1 mit jeweils zwei Anschlusseinrichtungen für Kühlflüssigkeit an gegenüberliegenden Hauptseiten 2 a/b , mit Lastanschlusseinrichtungen 24, 26 an den jeweiligen Längsseiten 3 a/b und mit Steueranschlusseinrichtungen 28 an den jeweiligen Schmalseiten 4a. Mittels der Anschlusseinrichtungen ist der Vor- 12 und Rücklauf 14 der Leistungshalbleitermodule 1 zu einem Kühlkreislauf verbunden. Hierzu sind der Vorlaufzufluss und der Rücklaufzufluss eines Leistungshalbleitermoduls mit dem Rücklaufabfluss des nachfolgenden Leistungshalbleitermoduls unmittelbar ausschließlich unter zusätzlicher Anordnung von externen Dichteinrichtungen zwischen den zu verbindenden zugeordneten Anschlusseinrichtungen verbunden.

Zur Herstellung einer flüssigkeitsdichten Verbindung sind die Leistungshalbleitermodule 1 miteinander verschraubt, vgl. Fig. 3, oder mittels einer Klemmeinrichtung kraftschlüssig verbunden.

Die Lasteingangsanschlusseinrichtungen 24, hier die Gleichstromanschlusseinrichtungen, sind einer ersten Längsseite 3a und die Lastausgangsanschlusseinrichtungen 26, hier die Wechselspannungsanschlusseinrichtungen, sind an der gegenüberliegen Längsseiten 3b angeordnet und durchdringen das jeweilige Gehäuse an zugeordneten Ausnehmungen 34, 36. Diese Ausgestaltung ergibt für eine auszubildende Wechselrichterschaltung enorme Vorteile, da somit die Gleichspannungs- von der Wechselspannungsseite getrennt ist. Dadurch kann gleichspannungsseitig die Anbindung an einen Gleichspannungszwischenkreis in kompakter und niederinduktiver Weise vorgesehen sein. Ebenso kann aufgrund ausreichend Bauraumes die wechselspannungsseitige Anbindung anforderungsgemäß vorgesehen werden.

Die Hilfsanschlusseinrichtungen 28 sind an einer Schmalseite 4a vorgesehen und beeinflussen daher den Gestaltungsspielraum für die Lastverbindungen in keinster Weise. Die Hilfsanschlusseinrichtungen 28 sind mit einer mehrteiligen externen Steuerplatine 40 verbunden, die ggf. wie dargestellt zur staub- und feuchtigkeitsdichten Verkapselung ein geeignetes eigenes Gehäuse aufweisen kann.

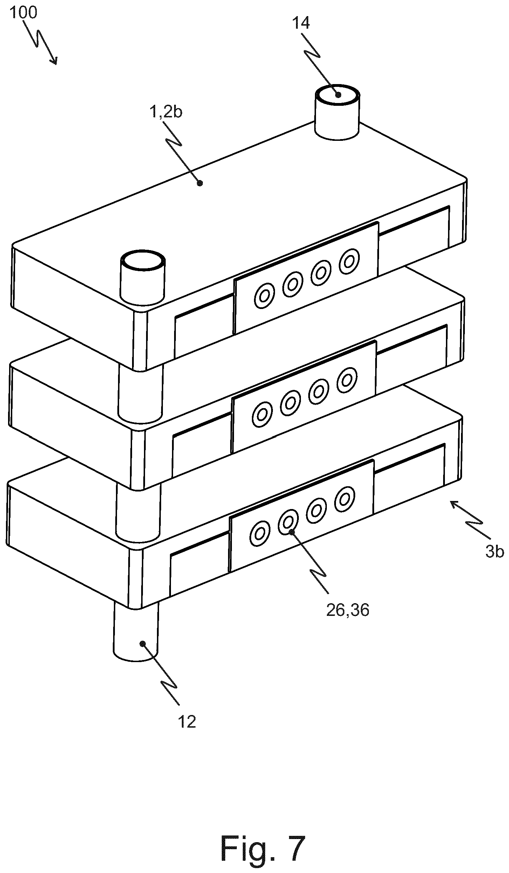

Figur 7 zeigt eine dreidimensionale Ansicht einer zweiten Ausgestaltung der erfindungsgemäßen Anordnung 100. Dargestellt ist eine Mehrzahl von anreihbaren Leistungshalbleitermodulen 1 mit jeweils zwei Anschlusseinrichtungen für Kühlflüssigkeit an gegenüberliegenden Hauptseiten und mit Lastanschlusseinrichtungen 24, 26 an den jeweiligen Längsseiten 3 a/b. Die Steueranschlusseinrichtungen an den jeweiligen Schmalseiten sind nicht dargestellt. Mittels der Anschlusseinrichtungen ist der Vor- 12 und Rücklauf 14 der Leistungshalbleitermodule 1 zu einem Kühlkreislauf verbunden. Hierzu sind der Vorlaufzufluss und der Rücklaufzufluss eines Leistungshalbleitermoduls mit dem Rücklaufabfluss des nachfolgenden Leistungshalbleitermoduls mittelbar unter zusätzlicher Anordnung von Dichteinrichtung und durchströmbaren Distanzstücken zwischen den zu verbindenden zugeordneten Anschlusseinrichtungen verbunden.

Zur Ausbildung der Anordnung 100 werden vorzugsweise nur die jeweiligen flüssigkeitsdichten Verbindungen hergestellt. Hierdurch entsteht ein Verbund, der in einer nicht dargestellten Halteeinrichtung angeordnet werden kann. Alternativ können die Leistungshalbleitermodule 1, ggf. unter Hinzufügen notwendiger Abstandshalter, miteinander verschraubt sein, vgl. Fig. 3.

## Patentansprüche

1. Anreihbares Leistungshalbleitermodul (1), mit einer quaderförmigen, jeweils zwei sich jeweils paarweise gegenüberliegenden Haupt- (2 a/b), Längs- (3 a/b) und Schmalseiten (4 a/b) aufweisenden Grundform, mit einer durchströmbaren U-förmig ausgebildeten Kühleinrichtung (10), einer leistungselektronischen Schalteinrichtung (20), die in der Ausnehmung der der U-förmig ausgebildeten Kühleinrichtung (10) angeordnet ist, und einem Gehäuse (30) zur Überdeckung der leistungselektronischen Schalteinrichtung (20),
wobei die Kühleinrichtung (10) ein Kühlvolumen (16) mit mindestens einer Kühlfläche (160, 162), auf der die leistungselektronische Schalteinrichtung (20) angeordnet und über diese thermisch mit einer Kühlflüssigkeit verbunden ist, und vier Anschlusseinrichtungen (110, 120, 130, 140) für die Kühlflüssigkeit aufweist, die paarweise an den Hauptseiten (2 a/b) angeordnet sind,
wobei die Anschlusseinrichtungen (110, 120, 130, 140) für die Kühlflüssigkeit ausgebildet sind als jeweils ein Vorlaufzu- (110) und ein Vorlaufabfluss (120) sowie als ein Rücklaufzu- (130) und ein Rücklaufabfluss (140) und
wobei die leistungselektronische Schalteinrichtung (20) Lasteingangs- (24) und Lastausgangsanschlusseinrichtungen (26) aufweist, die jeweils an einer oder beiden Längsseiten (3 a/b) angeordnet sind sowie eine Steueranschlusseinrichtung (28), die an einer Schmalseite (4 a/b) des Leistungshalbleitermoduls (1) angeordnet ist.

2. Leistungshalbleitermodul nach Anspruch 1, wobei
das Gehäuse (30) eine leistungselektronische Schaltung (22) der leistungselektronischen Schalteinrichtung (20) überdeckt und Ausnehmungen (34, 36, 38) für deren Last- und Steueranschlusseinrichtungen (24, 26, 28) aufweist.

3. Leistungshalbleitermodul nach einem der vorhergehenden Ansprüche, wobei das Gehäuse (30) als eine staub- und feuchtigkeitsdichte Verkapselung ausgebildet ist, die entweder ausschließlich die leistungselektronische Schaltung (22) oder die leistungselektronische Schaltung (22) und die Kühleinrichtung (10) einschließt.

4. Leistungshalbleitermodul nach einem der vorhergehenden Ansprüche, wobei die mindestens eine Kühlfläche (160, 162) der Kühleinrichtung (10) parallel zu den Hauptseiten (2 a/b) angeordnet ist.

5. Leistungshalbleitermodul nach einem der Ansprüche 2 bis 4, wobei die leistungselektronische Schaltung (22) auf zwei sich gegenüberliegenden Kühlflächen (160, 162) der Kühleinrichtung (10) angeordnet ist und hierbei mindestens zwei Schaltmodule (220) aufweist.

6. Leistungshalbleitermodul nach einem der vorhergehenden Ansprüche, wobei der Vorlaufzufluss (110) und der Rücklaufabfluss (140), sowie der Vorlaufabfluss (120) und der Rücklaufzufluss (130) jeweils auf einer Hauptseite (2 a/b) oder wobei
der Vorlaufzufluss (110) und der Rücklaufzufluss (130), sowie der Vorlaufabfluss (120) und der Rücklaufabfluss (140) jeweils auf einer Hauptseite (2 a/b) angeordnet sind.

7. Leistungshalbleitermodul nach Anspruch 6, wobei
zwischen dem Vorlaufzu- (110) und dem Vorlaufabfluss (120) ein erster Abzweig (122) sowie zwischen Rücklaufzu- (130) und Rücklaufabfluss (140) ein zweiter Abzweig (142) angeordnet sind, wodurch das Kühlvolumen (16) der Kühleinrichtung (10) mit Kühlflüssigkeit vom Vorlauf (12) zum Rücklauf (14) durchströmbar ist.

8. Anordnung (100) aus einer Mehrzahl von Leistungshalbleitermodulen (1) nach einem der vorhergehenden Ansprüche, wobei die Leistungshalbleitermodule (1) aneinandergereiht sind, indem der Vorlaufabfluss (120) eines Leistungshalbleitermoduls (1) mit dem Vorlaufzufluss (110) und der Rücklaufzufluss (130) mit dem Rücklaufabfluss (140) des nachfolgenden Leistungshalbleitermoduls mittelbar oder unmittelbar verbunden sind oder wobei die Leistungshalbleitermodule (1) aneinandergereiht sind indem der Vorlaufabfluss (120) eines Leistungshalbleitermoduls (1) mit dem Vorlaufzufluss (110) und der Rücklaufabfluss (140) mit dem Rücklaufzufluss (130) des nachfolgenden Leistungshalbleitermoduls mittelbar oder unmittelbar verbunden sind.

9. Anordnung nach Anspruch 8, wobei
die Lasteingangs- (24) und Lastausgangsanschlusseinrichtungen (26) aller Leistungshalbleitermodule (1) jeweils auf der gleichen Längsseite (3 a/b) angeordnet sind.

10. Anordnung nach Anspruch 8, wobei
die Steueranschlusseinrichtung (28) aller Leistungshalbleitermodule (1) jeweils auf der gleichen Schmalseite (4 a/b) angeordnet sind.

11. Anordnung nach Anspruch 8 oder 10, wobei
mindestens zwei Steueranschlusseinrichtungen (28) von zugeordneten benachbarten Leistungshalbleitermodulen (1) mit einer gemeinsamen externen Steuerplatine (40) verbunden sind.

12. Anordnung nach Anspruch 11, wobei
diejenigen Leistungshalbleitermodule (1), deren Steueranschlusseinrichtungen (28) mittels einer gemeinsamen externen Steuerplatine (40) verbundenen sind, einer elektrischen Phase eines Wechselstromsystems zugeordnet sind.

## Claims

1. Modular power semiconductor module (1), having a parallelepipedal basic shape which has two main (2 a/b), longitudinal (3 a/b) and narrow (4 a/b) sides, respectively, which are opposite one another in respective pairs, having a cooling device (10) of U-shaped design which is capable of carrying a flow, having a power electronics switching device (20) which is arranged in the recess in the cooling device (10) of U-shaped design, and having a housing (30) for covering the power electronics switching device (20),
wherein the cooling device (10) has a cooling volume (16) having at least one cooling face (160, 162) on which the power electronics switching device (20) is arranged and by means of which it is thermally connected to a cooling liquid, and four connection devices (110, 120, 130, 140) for the cooling liquid which are arranged in pairs on the main sides (2 a/b),
wherein the connection devices (110, 120, 130, 140) for the cooling liquid are designed as a flow inflow (110) and a flow outflow (120) and as a return inflow (130) and a return outflow (140), respectively, and
wherein the power electronics switching device (20) has load input connection devices (24) and load output connection devices (26) which are respectively arranged on one or both longitudinal sides (3 a/b) and also a control connection device (28) which is arranged on a narrow side (4 a/b) of the power semiconductor module (1).

2. Power semiconductor module according to Claim 1, wherein
the housing (30) covers a power electronics circuit (22) of the power electronics switching device (20) and has recesses (34, 36, 38) for the load and control connection devices (24, 26, 28) of said power electronics circuit.

3. Power semiconductor module according to either of the preceding claims, wherein
the housing (30) is in the form of an encapsulation which is impervious to dust and moisture and which encloses either exclusively the power electronics circuit (22) or the power electronics circuit (22) and the cooling device (10) .

4. Power semiconductor module according to one of the preceding claims, wherein
the at least one cooling face (160, 162) of the cooling device (10) is arranged parallel to the main sides (2 a/b).

5. Power semiconductor module according to one of Claims 2 to 4, wherein
the power electronics circuit (22) is arranged on two opposite cooling faces (160, 162) of the cooling device (10) and in this arrangement has at least two switching modules (220).

6. Power semiconductor module according to one of the preceding claims, wherein
the flow inflow (110) and the return outflow (140), and the flow outflow (120) and the return inflow (130), are respectively arranged on one main side (2 a/b) or wherein
the flow inflow (110) and the return inflow (130), and the flow outflow (120) and the return outflow (140), are respectively arranged on one main side (2 a/b).

7. Power semiconductor module according to Claim 6, wherein
a first branch (122) is arranged between the flow inflow (110) and the flow outflow (120) and a second branch (142) is arranged between return inflow (130) and return outflow (140), as a result of which the cooling volume (16) of the cooling device (10) is able to carry a flow of cooling liquid from the flow (12) to the return (14).

8. Arrangement (100) comprising a plurality of power semiconductor modules (1) according to one of the preceding claims, wherein the power semiconductor modules (1) are strung together in modular fashion by virtue of the flow outflow (120) of a power semiconductor module (1) being connected to the flow inflow (110), and the return inflow (130) being connected to the return outflow (140), of the downstream power semiconductor module indirectly or directly or wherein the power semiconductor modules (1) are strung together in modular fashion by virtue of the flow outflow (120) of a power semiconductor module (1) being connected to the flow inflow (110), and the return outflow (140) being connected to the return inflow (130), of the downstream power semiconductor module indirectly or directly.

9. Arrangement according to Claim 8, wherein
the load input connection devices (24) and load output connection devices (26) of all the power semiconductor modules (1) are respectively arranged on the same longitudinal side (3 a/b).

10. Arrangement according to Claim 8, wherein
the control connection devices (28) of all the power semiconductor modules (1) are respectively arranged on the same narrow side (4 a/b).

11. Arrangement according to Claim 8 or 10, wherein at least two control connection devices (28) of associated adjacent power semiconductor modules (1) are connected to a common external control board (40).

12. Arrangement according to Claim 11, wherein
those power semiconductor modules (1) which have control connection devices (28) connected by means of a common external control board (40) are associated with one electrical phase of an AC system.

## Revendications

1. Module semiconducteur de puissance (1) juxtaposable, ayant une forme de base parallélépipédique qui possède respectivement deux côtés principaux (2 a/b), longitudinaux (3 a/b) et étroits (4 a/b) qui sont respectivement opposés par paires, comprenant un dispositif de refroidissement (10) réalisé en forme de U qui peut être traversé par un courant, un dispositif de commutation (20) électronique de puissance qui est disposé dans la cavité du dispositif de refroidissement (10) réalisé en forme de U et un boîtier (30) servant à recouvrir le dispositif de commutation (20) électronique de puissance,
le dispositif de refroidissement (10) possédant un volume de refroidissement (16) pourvu d'au moins une surface de refroidissement (160, 162) sur laquelle le dispositif de commutation (20) électronique de puissance est disposé et relié thermiquement par le biais de celle-ci à un liquide de refroidissement, et quatre dispositifs de raccordement (110, 120, 130, 140) pour le liquide de refroidissement, lesquels sont disposés par paires sur les côtés principaux (2 a/b), les dispositifs de raccordement (110, 120, 130, 140) pour le liquide de refroidissement étant respectivement réalisés sous la forme d'une amenée (110) et d'une évacuation d'aller (120) ainsi que d'une amenée (130) et d'une évacuation de retour (140) et
le dispositif de commutation (20) électronique de puissance possédant des dispositifs de raccordement d'entrée de charge (24) et de sortie de charge (26) qui sont respectivement disposés sur un ou les deux côtés longitudinaux (3 a/b) ainsi qu'un dispositif de raccordement de commande (28) qui est disposé sur un côté étroit (4 a/b) du module semiconducteur de puissance (1).

2. Module semiconducteur de puissance selon la revendication 1, le boîtier (30) recouvrant un circuit électronique de puissance (22) du dispositif de commutation (20) électronique de puissance et possédant des cavités (34, 36, 38) pour ses dispositifs de raccordement de charge et de commande (24, 26, 28).

3. Module semiconducteur de puissance selon l'une des revendications précédentes, le boîtier (30) étant réalisé sous la forme d'un encapsulage hermétique à la poussière et à l'humidité, lequel contient soit exclusivement le circuit électronique de puissance (22), soit le circuit électronique de puissance (22) et le dispositif de refroidissement (10).

4. Module semiconducteur de puissance selon l'une des revendications précédentes, l'au moins une surface de refroidissement (160, 162) du dispositif de refroidissement (10) étant disposée parallèlement aux côtés principaux (2 a/b).

5. Module semiconducteur de puissance selon l'une des revendications 2 à 4, le circuit électronique de puissance (22) étant disposé sur deux surfaces de refroidissement (160, 162) opposées l'une à l'autre du dispositif de refroidissement (10) et possède à cette occasion au moins deux modules de commutation (220).

6. Module semiconducteur de puissance selon l'une des revendications précédentes, l'amenée d'aller (110) et l'évacuation de retour (140) ainsi que l'évacuation d'aller (120) et l'amenée de retour (130) étant respectivement disposés sur un côté principal (2 a/b) ou
l'amenée d'aller (110) et l'amenée de retour (130) ainsi que l'évacuation d'aller (120) et l'évacuation de retour (140) étant respectivement disposés sur un côté principal (2 a/b).

7. Module semiconducteur de puissance selon la revendication 6, une première dérivation (122) étant disposée entre l'amenée d'aller (110) et l'évacuation d'aller (120) ainsi qu'une deuxième dérivation (142) entre l'amenée de retour (130) et l'évacuation de retour (140), le volume de refroidissement (16) du dispositif de refroidissement (10) pouvant ainsi être traversé par un courant de liquide de refroidissement de l'aller (12) vers le retour (14).

8. Arrangement (100) composé d'une pluralité de modules semiconducteurs de puissance (1) selon l'une des revendications précédentes, les modules semiconducteurs de puissance (1) étant juxtaposés en ce que l'évacuation d'aller (120) d'un module semiconducteur de puissance (1) est reliée directement ou indirectement à l'amenée d'aller (110) et l'amenée de retour (130) à l'évacuation de retour (140) du module semiconducteur de puissance suivant, ou les modules semiconducteurs de puissance (1) étant juxtaposés en ce que l'évacuation d'aller (120) d'un module semiconducteur de puissance (1) est reliée directement ou indirectement à l'amenée d'aller (110) et l'évacuation de retour (140) à l'amenée de retour (130) du module semiconducteur de puissance suivant.

9. Arrangement selon la revendication 8, les dispositifs de raccordement d'entrée de charge (24) et de sortie de charge (26) de tous les modules semiconducteurs de puissance (1) étant respectivement disposés sur le même côté longitudinal (3 a/b).

10. Arrangement selon la revendication 8, le dispositif de raccordement de commande (28) de tous les modules semiconducteurs de puissance (1) étant respectivement disposés sur le même côté étroit (4 a/b) .

11. Arrangement selon la revendication 8 ou 10, au moins deux dispositifs de raccordement de commande (28) de modules semiconducteurs de puissance (1) voisins associés étant reliés à une platine de commande (40) externe commune.

12. Arrangement selon la revendication 11, les modules semiconducteurs de puissance (1) dont les dispositifs de raccordement de commande (28) sont reliés au moyen d'une platine de commande (40) externe commune étant associés à une phase électrique d'un système à courant alternatif.
